# EUROPÄISCHE PATENTANMELDUNG

(11) **EP 1 160 982 A1**
(43) Veröffentlichungstag der Anmeldung: **05.12.2001**
(21) Anmeldenummer: 01108456.3
(22) Anmeldetag: 04.04.2001
(51) Int. Cl.: H03K 17/94

(54) **Signalgeber**

(30) Priorität: 25.05.2000 DE 10027846
(71) Anmelder: Siemens Building Technologies AG, 8008 Zürich (CH)
(72) Erfinder: Lochschmied, Rainer Dr., 76287 Rheinstetten (DE)
(74) Vertreter: Zedlitz, Peter, Dipl.-Inf.

(57) **Zusammenfassung**

Ein Signalgeber, der an eine Gleichspannungsquelle (16) anschließbar ist, enthält einen Signalerzeuger (14) und einen Sender (15), welche erfindungsgemäß in Reiheschaltung von der Gleichspannungsquelle gespeist werden.

## Beschreibung

Die Erfindung betrifft einen Signalgeber, der an eine Gleichspannungsquelle anschließbar ist, ausgestattet mit zumindest einem Signalerzeuger, der an die Ausgangsleitungen der Gleichspannungsquelle geschaltet ist und ein Signal erzeugt, und mit zumindest einem Sender, der durch die Gleichspannungsquelle gespeist wird und vom Signal angesteuert wird.

Solche Signalgeber sind bekannt und werden insbesondere für die Entkopplung von Stromkreisen benutzt. Die Speisung des Signalgebers erfolgt durch eine Gleichspannungsquelle. Die Gleichspannungsquelle enthält einen Speicher für elektrische Energie, in manche Fällen eine Batterie. In anderen Fällen ist die Gleichspannungsquelle ein Netzteil und enthält einen Speicher für elektrische Energie, beispielsweise einen Kondensator, der so geschaltet ist, dass er während des Betriebes zeitweise aus einem Wechselspannungsnetz geladen und zeitweise über ihrer Last entladen wird.

Der Speicher kann seine Ausgangsspannung nicht auf einem völlig stabilen Wert halten. Darüber hinaus kann die Größe der Netzspannung variieren. Netzteile umfassen deswegen häufig ein Spannungsreferenzelement, das während des Betriebes die Spannung am Ausgang konstant zu halten versucht. Als einfacher Aufbau eines Netzteils ist ein Widerstand oder eine Zenerdiode als Spannungsglätter zwischen den Ausgangsleitungen geschaltet.

Bei bekannten Signalgebern, die mit Gleichspannung betrieben werden und sowohl einen Signalerzeuger als einen Sender aufweisen, sind diese beiden Teile zur Speisung parallel am Ausgang einer Gleichspannungsquelle geschaltet. Das Signal des Signalerzeugers muss somit dem Sender Informationen übergeben, aber nicht auch zu dessen Speisung dienen.

Die Gleichspannungsquelle für diese Signalgeber wird unnötig belastet, erzeugt unnötige Wärme und weist im Falle einer Batterie eine unbefriedigend kurze Standzeit, im Falle eines Netzteils teilweise unnötig große und teuere elektrische Komponenten auf.

Die Erfindung liegt die Aufgabe zugrunde, solche Signalgeber zu verbessern. Beim Signalgebern gemäss der Erfindung ist der Sender so geschaltet, dass er in Reihe zum Signalerzeuger gespeist wird.

Die Erfindung beruht auf den Gedanken, dass der Sender in der Praxis mit unterschiedlicher und weniger stabiler Spannung als der des Signalerzeugers arbeiten kann. Entweder ist in einer Parallelschaltung die angebotene Spannung für einen der Beiden höher als notwendig, oder eine Spannung muß begrenzt werden. Die Reihenschaltung ermöglicht eine Verringerung der benötigten elektrischen Leistung und der erzeugten Wärme.

Vorteilhaft umfasst der Sender zumindest ein Schaltelement, beispielsweise einen Transistor. Das Schaltelement kann die Speisung des Senders durch die Gleichspannungsquelle beeinflussen und es wird vom Signal angesteuert. Die Ansteuerung des Senders durch das Signal wird so mittels eines Schaltelementes ausgeführt.

Der Sender kann beispielsweise einen Optokoppler umfassen, der einer unabhängigen Schaltung Signalinformationen sendet. Alternativerweise kann ein Relais dazu dienen, Signalinformationen in mechanischer Form weiterzugeben.

Wegen der Flexibilität des zulässigen Betriebsstromes von optischen Dioden ist eine Ausführung der Erfindung, bei der der Sender zumindest eine optische Diode umfasst, besonders vorteilhaft.

Zum Beispiel sind in dem Sender eine optische Diode und ein Transistor parallel geschaltet. Während der Transistor gesperrt ist, fließt ein Speisestrom durch die Diode und schaltet diese ein. Das Signal vom Signalerzeuger wird z. B. der Basis des Transistors zugeführt. Sobald das Signal den Transistor schaltet, wird die Speisespannung über der optischen Diode kurzgeschlossen und deren Betätigung beendet.

Vorteilhaft ist der Sender zwischen einem Speicher für elektrische Energie in der Gleichspannungsquelle, beispielsweise einem Kondensator, und einer Ausgangsleitung der Gleichspannungsquelle geschaltet.

Durch diese Aufnahme des Senders in der Schaltung der Gleichspannungsquelle bleibt ihre Ausgangsspannung, welche seriell an dem Signalerzeuger angeboten wird, weitgehend stabil und von einer Betätigung des Senders weitgehend unberührt. Hier wird die Eigenschaft des Senders benutzt, dass er im Vergleich zum Signalerzeuger eine kleine Speisespannung benötigt und wenig empfindlich für etwaige Stromschwankungen ist.

Insbesondere kommen die Vorteile der Erfindung zum Tragen, wenn der Signalerzeuger ein Messergebnissauswerter eines Brenners ist, beispielsweise ein Öl- oder Gasbrenner einer Heizungsanlage. In Geräte mit Sicherheitsanforderungen ist eine erhebliche Wärmeerzeugung problematisch und fordert teure Kühlungsmaßnahmen. Solche Geräte erfordern oft eine galvanische Trennung, welche mittels eines Signalgebers und eines Signalempfängers erreicht wird. Seriengeräte sollen aber möglichst preiswerte Komponenten aufweisen. Geräte, welche ständig am Netz betrieben werden, sollten dazu möglichst wenig Leistung aufnehmen. Alle diese Anforderungen gelten für Brennersteuerungen.

Im folgenden werden Ausführungsbeispiele der Erfindung anhand der Zeichnungen näher erläutert. Es zeigt
Figur 1 einen Signalerzeuger,
Figur 2 einen Signalgeber und eine Gleichspannungsquelle und
Figur 3 einen weiteren Signalgeber und eine Gleichspannungsquelle.

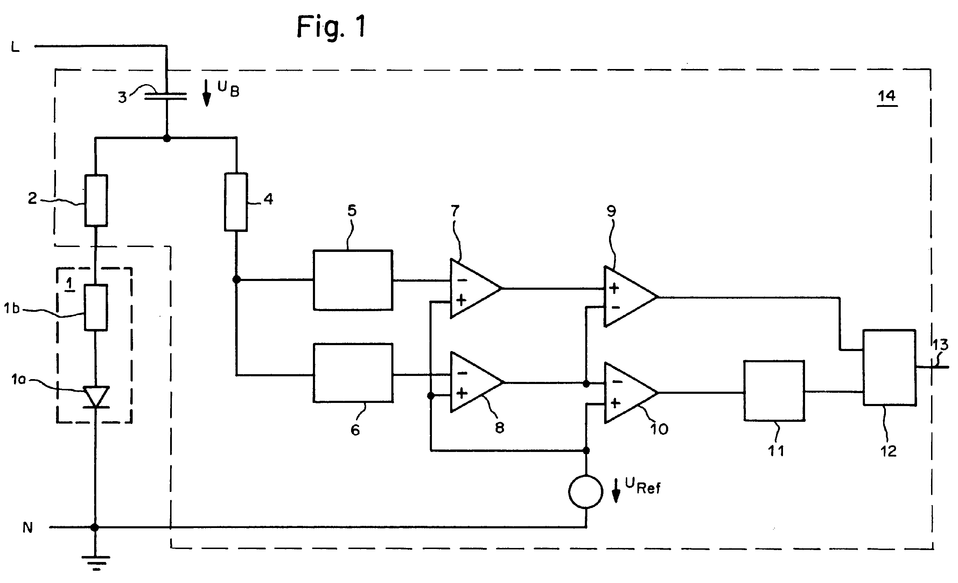

Der in der Figur 1 dargestellte Signalerzeuger ist ein Ionisationsauswerter 14. Im Flammenbereich eines Gasbrenners ist eine nicht dargestellte Ionisationselektrode angeordnet. Der Ionisationsauswerter 14 erzeugt ein Ionisationssignal 13 für die Flammenüberwachung und für die Regelung des Luft-Gasverhältnis des Brenners.

In einer Ersatzschaltung ist die Flamme 1 durch eine Diode 1a und einen Widerstand 1b dargestellt. Über Netzleiter L und N wird eine Wechselspannung von beispielsweise 230V angelegt. Wenn eine Flamme 1 vorhanden ist, fließt wegen der Flammendiode 1a durch den Blockkondensator 3 in der positiven Halbwelle ein größerer Strom als in der negativen Halbwelle. Dadurch bildet sich zwischen L und einem zum Zweck des Berührschutzes angebrachten Widerstandes 2 eine positive Gleichspannung U_{B} am Blockkondensator 3 aus.

Durch einen Entkopplungswiderstand 4 fließt daher ein Gleichstrom von N zum Blockkondensator 3. Die Höhe des Gleichstromes hängt dabei von U_{B} und damit direkt vom Flammenwiderstand 1b ab. Der Flammenwiderstand 1b beeinflusst ebenfalls den Wechselstrom durch den Entkoppelwiderstand 4, allerdings in unterschiedlichem Maß gegenüber dem Gleichstrom. Durch den Widerstand 4 fließt somit ein Gleichstrom und ein Wechselstrom wie oben beschrieben.

Dem Widerstand 4 ist nun ein Hochpass 5 und ein Tiefpass 6 nachgeschaltet. Durch den Hochpass 5 wird der Wechselstrom ausgefiltert und der Gleichspannungsanteil abgeblockt. Durch den Tiefpass wird der vom Flammenwiderstand 1b abhängige Gleichspannungsanteil ausgefiltert und der Wechselstrom im wesentlichen abgeblockt. In einem Operationsverstärker 7 wird der aus dem Hochpass 5 fließende Wechselstrom verstärkt und eine Referenzspannung U_{Ref} zuaddiert. In einem Operationsverstärker 8 wird der aus dem Hochpass 6 fließende Gleichstrom mit eventuell geringen Wechselstromanteilen verstärkt und die Referenzspannung U_{Ref} zuaddiert.

Die Referenzspannung U_{Ref} kann beliebig, zum Beispiel U_{Ref} = 0 gewählt werden, sie wird jedoch vorzugsweise so gewählt, dass die Operationsverstärker 7, 8 und Komparatoren 9, 10 nur eine Versorgung benötigen.

An einem Komparator 9 werden die aus dem Operationsverstärker 7 austretende Wechselspannung und die aus dem Operationsverstärker 8 austretende Gleichspannung miteinander verglichen und ein pulsweitenmoduliertes (PWM) Signal erzeugt. Ändert sich die Amplitude der Netzspannung, so ändern sich Wechselspannung und Gleichspannung im gleichen Verhältnis, das PWM-Signal ändert sich nicht. Der Signalhub des PWM-Signals kann mittels der Operationsverstärker 7 und 8 in einem weiten Bereich zwischen τ = 0 und τ = 50% Tastverhältnis eingestellt werden.

Der Gleichspannungsanteil U₌ wird in einem Komparator 10 mit der Referenzspannung U_{Ref} verglichen. Ist eine Flamme vorhanden, ist der Gleichspannungsanteil größer als die Referenzspannung (U₌ > U_{Ref}) und der Komparatorausgang des Komparators 10 schaltet auf 0. Ist keine Flamme vorhanden, so ist der Gleichspannungsanteil ungefähr gleich der Referenzspannung (U₌ ≈ U_{Ref}). Wegen dem, dem Gleichspannungsanteil überlagerten, geringen Wechselspannungsanteil, den der Tiefpass 6 nicht ausfiltert, unterschreitet der Gleichspannungsanteil kurzzeitig die Referenzspannung und am Komparatorausgang des Komparators 10 erscheinen Impulse. Diese Impulse werden auf ein nachtriggerbares Monoflop 11 gegeben.

Das Monoflop 11 wird so getriggert, dass die aus dem Komparator 10 ausgegebene Impulsfolge schneller kommt als die Impulsdauer des Monoflops ist. Dadurch erscheint, wenn keine Flamme vorhanden ist am Ausgang des Monoflops konstant eine 1. Ist eine Flamme vorhanden, so wird das Monoflop nicht getriggert, und am Ausgang erscheint permanent eine 0. Das nachtriggerbare Monoflop 11 bildet somit einen "missing pulse detector" welches das dynamische Ein-/Aus-Signal in ein statisches Ein-/Aus-Signal umwandelt.

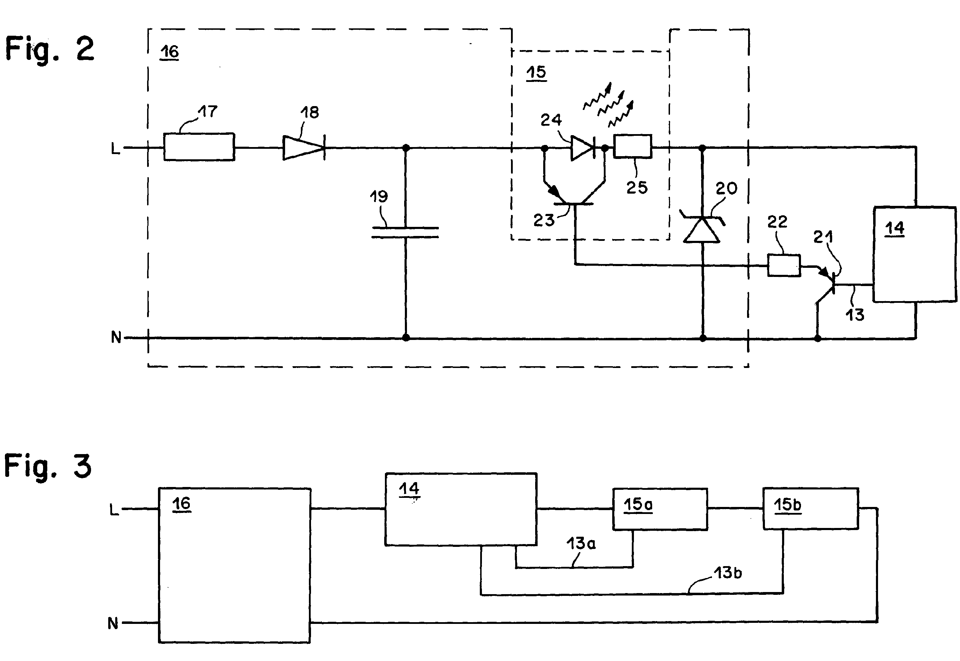

Beide Signale, das PWM-Signal und das Flammensignal können nun separat weiterverarbeitet werden oder aber mittels eines Oder-Gliedes 12 verknüpft werden. Als Ausgang des Oder-Gliedes 12 zeigt sich bei vorhandener Flamme ein PWM-Signal, dessen Tastverhältnis ein Maß für den Flammenwiderstand 1b ist. Dieses Ionisationssignal 13 wird einer nicht dargestellten Schutzkleinspannungsseite zu Regelungs- und Überwachungszwecken zugeführt. Ist keine Flamme vorhanden, ist der Ausgang des Oder-Gliedes permanent auf 1. Das Ionisationssignal 13 wird über eine weiter unten beschriebene Schaltungsanordnung auf eine in der Figur 2 dargestellte optische Diode 24 übertragen, um eine Schutztrennung zwischen der Netzseite und der Schutzkleinspannungsseite zu erreichen.

In der Figur 2 bildet der Ionisationsauswerter 14 zusammen mit einem optischen Sender 15 den erfindungsgemäßen Signalgeber, der von einer Gleichspannungsquelle 16 gespeist wird.

Über Netzleiter L und N wird eine Wechselspannung von beispielsweise 230V angelegt. Die Wechselspannung wird in einer Gleichspannungsquelle 16 durch einen Widerstand 17 abgedämpft und durch eine Diode 18 gleichgerichtet. In einer anderen Ausführung kann anstatt des Widerstandes 17 auch eine Kapazität in Serie zu einem kleinen Widerstand als Verbraucher verwendet werden, um vergleichsweise kleinere Verluste zu erhalten. Die so entstandenen Spannungshalbwellen laden zeitweise einen Kondensator 19, der als Speicher für elektrische Energie dient. Seine Kapazität, typisch 10 bis 1000 Mikrofarad, ist auf den erwarteten Verbrauch des Ionisationsauswerters 14 und des optischen Senders 15 abgestimmt. Am Ausgang der Gleichspannungsquelle 16 sorgt eine Zenerdiode 20 dafür, dass die Ausgangsgleichspannung weitgehend auf einem konstanten und stabilen Wert von beispielsweise 8 Volt oder 30 Volt liegt.

Übrigens sind alternativerweise zwei Zenerdioden in Reihe zwischen den Ausgangsleitungen der Gleichspannungsquelle 16 geschaltet. Es entsteht dadurch eine niedrigere Zwischengleichspannung, welche eine in der Figur 1 gezeigte Spannung U_{Ref} von ungleich Null bildet.

Somit wird der Ionisationsauswerter 14 mit einer konstanten und stabilen Gleichspannung gespeist. Diese Speisung versorgt insbesondere die in der Figur 1 gezeigten Operationsverstärker 7 und 8 und die Komparatoren 9 und 10.

Das Ionisationssignal 13 ist ein PWM-Signal, das zu Schutztrennungszwecken in ein optisches PWM-Signal umgewandelt werden soll. Dazu wird im PWM-Takt ein Transistor 21 geschaltet, und über einem Widerstand 22 im gleichen Takt ein Transistor 23 angesteuert.

In dem optischen Sender 15 ist die optische Diode 24 parallel zum Transistor 23 geschaltet. Ein Widerstand 25 verringert den Strom durch beide. Wenn der Transistor 23 sperrt, steht eine Speisespannung von typisch ungefähr 1,2 Volt über der optischen Diode 24, was sie dazu bringt, zu leuchten. Wenn aber der Transistor 23 durchschaltet, wird die optische Diode 24 kurzgeschlossen und leuchtet nicht mehr. Die wegen des Umschaltens des Transistors 23 entstehende Spannungsschwankungen werden weitgehend durch die Zenerdiode 20 gedämpft.

Die Figur 3 zeigt einen weiteren erfindungsgemäßen Signalgeber und eine Gleichspannungsquelle. Die Gleichspannungsquelle 16 erzeugt eine Gleichspannung, die den Ionisationsauswerter 14 und die zwei optischen Sender 15a und 15b speist. Die beide optische Sender umfassen eigene optische Dioden, welche beispielsweise in unterschiedene Farben leuchten können bei Ansteuerung durch das Signal 13a, beziehungsweise 13b.

Die erlaubte Speisespannung für den Ionisationsauswerter 14 ist im Vergleich zu der für die optischen Sender 15a und 15b dermaßen gewählt, dass ihre Änderung infolge des Einschaltens oder Ausschaltens der optischen Sender 15a und 15b relativ wenig Einfluss hat.

## Patentansprüche

1. Signalgeber, der an eine Gleichspannungsquelle (16) anschließbar ist, mit zumindest einem Signalerzeuger (14), der an die Ausgangsleitungen der Gleichspannungsquelle (16) geschaltet ist und ein Signal (13) erzeugt, und mit zumindest einem Sender (15), der durch die Gleichspannungsquelle (16) gespeist wird und vom Signal (13) angesteuert wird,
**dadurch gekennzeichnet, dass** der Sender (15) so geschaltet ist, dass er in Reihe zum Signalerzeuger (14) gespeist wird.

2. Signalgeber nach Anspruch 1,
**dadurch gekennzeichnet, dass** der Sender (15) zumindest ein Schaltelement (23) umfasst, das Schaltelement (23) die Speisung des Senders (15) durch die Gleichspannungsquelle (16) beeinflussen kann und das Schaltelement (23) vom Signal (13) angesteuert wird.

3. Signalgeber nach Anspruch 1 oder 2,
**dadurch gekennzeichnet, dass** der Sender (15) zumindest eine optische Diode (24) umfasst.

4. Signalgeber nach einem der vorangehenden Ansprüche,
**dadurch gekennzeichnet, dass** der Sender (15) zwischen einem Speicher für elektrische Energie (19) in der Gleichspannungsquelle (16) und einer Ausgangsleitung der Gleichspannungsquelle (16) geschaltet ist.

5. Signalgeber nach einem der vorangehenden Ansprüche,
**dadurch gekennzeichnet, dass** der Sender (15) an die Ausgangsleitungen der Gleichspannungsquelle (16) geschaltet ist.

6. Signalgeber nach einem der vorangehenden Ansprüche,
**dadurch gekennzeichnet, dass** der Signalerzeuger (14) ein Messergebnissauswerter eines Brenners ist.
